# EUROPEAN PATENT SPECIFICATION

(11) **EP 3 385 269 B1**
(45) Date of publication and mention of the grant of the patent: **19.02.2020**
(21) Application number: 16871092.9
(22) Date of filing: 02.12.2016
(51) Int. Cl.: C07F 7/24, H01L 51/42, H01L 31/0256, C01G 21/00, H01G 9/20, H01L 51/00

(54) **ORGANIC-INORGANIC HYBRID PEROVSKITE, METHOD FOR PREPARING SAME, AND SOLAR CELL COMPRISING SAME**
ORGANISCH-ANORGANISCHER HYBRIDER PEROWSKIT, VERFAHREN ZUR HERSTELLUNG DAVON UND SOLARZELLE DAMIT
PÉROVSKITE HYBRIDE ORGANIQUE-INORGANIQUE, PROCÉDÉ DE PRÉPARATION DE CELLE-CI, ET CELLULE SOLAIRE COMPRENANT CELLE-CI

(30) Priority: 04.12.2015 KR 20150172409; 31.10.2016 KR 20160142890
(43) Date of publication of application: 10.10.2018
(73) Proprietor: LG Chem, Ltd., Seoul 07336 (KR)
(72) Inventor: PARK, Eun Seok, Daejeon 34122 (KR); HONG, Sung Kil, Daejeon 34122 (KR); CHUN, Sung-Ho, Daejeon 34122 (KR)
(74) Representative: Hoffmann Eitle
(86) International application number: PCT/KR2016/014133
(87) International publication number: WO 2017/095196

(56) References cited:
- WO-A1-2016/038338
- NORMAN PELLET ET AL: "Mixed-Organic-Cation Perovskite Photovoltaics for Enhanced Solar-Light Harvesting", ANGEWANDTE CHEMIE INTERNATIONAL EDITION, vol. 53, no. 12, 19 February 2014 (2014-02-19), pages 3151-3157, XP55162823, ISSN: 1433-7851, DOI: 10.1002/anie.201309361
- FROST, J. M. ET AL.: 'Atomistic Origins of High-Pertèmnance in Hybrid Halide Perovskite Solar Cells' NANO LETTERS vol. 14, no. 5, 2014, pages 2584 - 2590, XP055357324
- LEGUY, A. M. A. ET AL.: 'The Dynamics of Methyl Ammonium Ions in Hybrid Organic-inorganic Perovskite Solar Cells' NATURE COMMUNICATIONS vol. 6, no. 7124, 29 May 2015, pages 1 - 10, XP055392619
- KIM, H. -B. ET AL.: 'Mixed Solvents for the Optimization of Morphology in Solution-processed, Inverted-type Perovskite/fullerene Hybrid Solar Cells' NANOSCALE vol. 6, no. 12, 2014, pages 6679 - 6683, XP055392621
- LEE, C. ET AL.: 'Organic-inorganic Hybrid Perovskites ABI3 (A = CH 3NH3, NH2CHNH2; B - Sn, Pb) as Potential Thermoelectric Materials: A Density Functional Evaluation' RSC ADVANCES vol. 5, no. 96, 10 September 2015, pages 78701 - 78707, XP055392623
- GONG, J. ET AL.: 'Electron-rotor Interaction in Organic-inorganic Lead Iodide Perovskites Discovered by Isotope Effects' THE JOURNAL OF PHYSICAL CHEMISTRY LETTERS vol. 7, 11 July 2016, pages 2879 - 2887, XP055392624

## Description

### [TECHNICAL FIELD]

This application claims priority to and the benefit of Korean Patent Application No. 10-2015-0172409 filed on December 4, 2015 and Korean Patent Application No. 10-2016-0142890 filed on October 31, 2016 with the Korean Intellectual Property Office.

The present invention relates to an organic-inorganic hybrid perovskite which can be used as an absorber of a solar cell, a method for preparing the same, and a solar cell comprising the same.

### [BACKGROUND ART]

In order to solve the depletion of fossil energy and global environmental problems caused by the use thereof, research into renewable and clean alternative energy sources such as solar energy, wind power, and water power has been actively conducted.

Of those, an interest in solar cells that can convert from solar light directly into electric energy has significantly increased. Here, the solar cell means a cell generating current-voltage using a photovoltaic effect in which the cell absorbs light energy from solar light to generate electrons and holes.

Recently, a n-p diode type single-crystal silicon (Si) based solar cell having photoelectric conversion efficiency of higher than 20% may be manufactured and actually has been used in solar power generation, and a solar cell using a compound semiconductor such as gallium arsenide (GaAs) having conversion efficiency higher than that of the n-p diode type single-crystal silicon (Si) based solar cell is present. However, since these inorganic semiconductors based solar cells require a significantly high-purity purified material for high efficiency, a large amount of energy is consumed in purifying a raw material, and expensive processing equipment is required during a single crystallization process or a thinning process using the raw material, such that there is a limitation in lowering a manufacturing cost of the solar cell, thereby blocking large-scale use of the solar cell.

Therefore, in order to manufacture the solar cell at low cost, a cost of a core material used in the solar cell or the manufacturing process of the solar cell should be greatly reduced, and research into a dye-sensitized solar cell and an organic solar cell that may be manufactured using an inexpensive material and process has been actively conducted as an alternative to the inorganic semiconductor based solar cell.

The dye-sensitized solar cell (DSSC) was initially developed by Michael Gratzel in 1991, a professor at EPFL in Switzerland and was reported in Nature (Vol 353, P. 737).

An early dye-sensitized solar cell had a simple structure in which a dye absorbing light was absorbed onto porous photo-anodes on a transparent electrode film, another conductive glass substrate was positioned on the top, and a liquid electrolyte was filled therebetween. An operation principle of the dye-sensitized solar cell is as follows. When dye molecules chemically absorbed onto surfaces of the porous photo-anodes absorb solar light, the dye molecules generate electron-hole pairs, and electrons are injected into a conduction band of semiconducting oxides used as the porous photo-anodes to be transported to the transparent conductive film, thereby generating current. The holes remaining in the dye molecules configure of complete solar cell circuits in a shape in which the holes are transported to photo-cathodes by hole conduction caused by oxidation-reduction reaction of a liquid or solid electrolyte or hole-conductive polymer, thereby performing external work.

In this DSSC configuration, the transparent conductive film was mainly made of fluorine doped tin oxide (FTO) or indium doped tin oxide (ITO), and nanoparticles having a broad band gap are used as the porous photo-anodes. As the dye, various materials capable of absorbing light particularly well and easily separating an exciton generated by the light since a lowest unoccupied molecular orbital (LUMO) energy level of the dye is higher than an energy level of the conduction band of the photo-anode material to thereby increase the efficiency of the solar cell are chemically synthesized and used. The maximum efficiency of a liquid type dye-sensitized solar cell reported up to now has been 11 to 12% for about 20 years. The liquid type dye-sensitized solar cell has relatively high efficiency to thereby make it possible to be commercialized. However, there are problems in stability according to time by a volatile liquid electrolyte and reducing cost due to using a high-cost ruthenium (Ru) based dye.

In order to solve these problems, research into uses of a non-volatile electrolyte using ionic solvent rather than the volatile liquid electrolyte, a gel-type polymer electrolyte, and an inexpensive pure organic dye has been conducted, but efficiency of a DSSC using these materials is lower than that of the DSSC using the volatile liquid electrolyte and ruthenium (Ru) based dye.

Meanwhile, the organic photovoltaic (OPV) that has been studied in earnest since the mid-1990 is configured of organic materials having electron donor (D, or often called a hole acceptor) characteristics and electron acceptor (A) characteristics. When the solar cell made of organic molecules absorbs the light, electrons and holes are formed, which are called exciton. The exciton moves to a D-A interface, such that an electric charge is separated, an electron moves to the electric acceptor, and the hole moves to the electron donor, thereby generating photo current.

Since a distance at which the exciton generated in the electron donor may move is around 10 nm, which is significantly short, photo active organic materials may not be thickly laminated, such that optical absorption spectra was low and the efficiency was low. In recent years, however, due to introduction of so-called bulk heterojunction (BHJ) concept of increasing a surface area at an interface and development of an electron donor organic material having a small band gap to easily absorb solar light of a wide range, the efficiency was significantly increased, such that an organic photovoltaic having efficiency of 8% or higher has been reported (Advanced Materials, 23(2011) 4636).

In the organic photovoltaic, a manufacturing process of a cell is simple due to high formability of the organic material, diversity thereof, and a low cost thereof, such that the organic photovoltaic may be manufactured at a low cost, as compared to the existing solar cell. However, the organic photovoltaic has a problem that a structure of BHJ is degraded by moisture in air or oxygen to rapidly decrease the efficiency thereof, that is, a problem in the stability of the solar cell. When a technology of completely sealing the solar cell is introduced in order to solve this problem, the stability may be increased, but a cost may also be increased.

As a method of solving a problem of the dye-sensitized solar cell by the liquid electrolyte, an all-solid state DSSC using Spiro-OMeTAD[2,22',7,77'-tetrkis (N,N-di-p-methoxyphenylamine)-9,99'-spirobi fluorine], which is a solid state hole conductive organic material rather than the liquid electrolyte to have efficiency of 0.74% was reported in Nature in 1998 by Michael Gratzel, a chemistry professor at EPFL in Switzerland, who is an inventor of the dye-sensitized solar cell.

Afterward, the efficiency was increased up to about 5.0% by optimizing the structure, improving interfacial properties, and improving hole conductivity. In addition, a solar cell using the inexpensive pure organic dye instead of the ruthenium based dye and using P3HT, PEDOT, or the like as a hole conductor has been manufactured, but efficiency of the solar cell is still low, at 2 to 7%.

Further, research into a solar cell using quantum dot nanoparticles as a light absorber rather than the dye and using hole conductive inorganic material or organic material rather than the liquid electrolyte has been reported. Many solar cells using CdSe, PbS or the like as the quantum dot and using conductive polymers such as spiro-OMeTAD or P3HT as the hole conductive organic material have been reported, but their efficiency is still very low, at 5% or less. In addition, about 6% efficiency was reported for Sb₂S₃ as a light absorbing inorganic material and PCPDTBT as a hole conductive inorganic material (Nano Letters, 11 (2011) 4789), but further improvement in efficiency has not been reported.

In addition, about 9% efficiency has been reported using substances with organic-inorganic hybrid perovskite structure instead of dyes for dye-sensitized solar cells rather than quantum dots made of pure minerals (Scientific Reports 2, 591). Besides, solar cells using perovskite are published, but there is no report on novel perovskite materials. Norman Pellet et al. discuss mixed-organic-cation perovskite photovoltaics that make use of a mixture of formamidinium and methylammonium cations in the A position of APbl₃ perovskite structure (Angewandte Chemie International Edition, vol. 53, no. 12, pages 3151-3157).

Therefore, the present inventor has conducted research to modify the structure of the organic-inorganic hybrid perovskite in order to improve the humidity and light stability of an organic-organic hybrid perovskite, and found that the organic-organic hybrid perovskite having a novel structure as described below satisfies the above requirements, thereby completing the present invention

### [DETAILED DESCRIPTION OF THE INVENTION]

### [Technical Problem]

It is an object of the present invention to provide an organic-inorganic hybrid perovskite which can be used as an absorber of a solar cell, and a method for preparing the same.

It is another object of the present invention to provide a solar cell comprising the above-described organic-inorganic hybrid perovskite.

### [Technical Solution]

In order to achieve the above objects, the present invention provides a compound represented by Chemical Formula 1 below:

[Chemical Formula 1] (NH₂CHNH₂MX₃)ₓ(AM'X'₃)₍₁₋ₓ₎

in Chemical Formula 1,
M is a divalent metal cation,
X is the same or different halogen,
A is CD₃₋ₐHₐN⁺D_{3-b}H_{b},
wherein a is an integer from 0 to 3, and b is an integer from 0 to 3, with the exception of the case where a is 3 and b is 3,
M' is a divalent metal cation,
X' are the same or different halogen, and
x is a real number of greater than 0 and less than 1.

The compound represented by Chemical Formula 1 is a perovskite compound. As used herein, the term "perovskite" is named after the Russian mineralogist, Lev Perovski, and refers to any material having a formula of AMX₃ consisting of cations (A and M) and an anion (X), and having the same type of structure as calcium titanium oxide (CaTiO₃), the first perovskite type material, which was discovered in the Ural mountains. In the case of perovskite used in a solar cell as in the present invention, a monovalent ammonium ion is usually used as a cation corresponding to A, and accordingly the term "organic-inorganic hybrid" is used.

CH₃NH₃⁺(methylammonium; MA) is typically known as a cation corresponding to A in the perovskite used in conventional solar cells. However, the perovskite including methylammonium has properties that are unstable to light, moisture and heat, and therefore, there is a problem that when the solar cell is operated, the light conversion efficiency deteriorates with the lapse of time. In addition, formamidinium(FA) is known as a cation corresponding to A, and it is known that perovskite containing it has a reduced bandgap compared to a perovskite containing methylammonium.

Further, perovskite including both methyl ammonium and formamidinium as cations corresponding to A has been reported, but there are disadvantages in that its stability to humidity and light is weak and the long-term stability deteriorates when applied to a solar cell.

Therefore, in the present invention, there is provided a perovskite containing both methylammonium and formamidinium as cations corresponding to A and having a structure in which at least one deuterium is substituted in methyl ammonium. When deuterium is substituted, the zero point energy (ZPE) is lowered due to the isotope effect, and it can have chemically stable properties. It was confirmed that in the case where deuterium was substituted as in the example described later, the efficiency of the solar cell was maintained for a long time as compared with the case where deuterium was not substituted.

Preferably, M is Pb²⁺, Sn²⁺, Pd²⁺, Cu²⁺, Ge²⁺, Sr²⁺, Cd²⁺, Ca²⁺, Ni²⁺, Mn²⁺, Fe²⁺, Co²⁺, Sn²⁺, Yb²⁺, or Eu²⁺. More preferably, M is Pb²⁺ or Sn²⁺, and most preferably Pb²⁺.

Further, preferably, each X is independently Cl⁻, Br⁻, or I⁻. Since the X may be the same as or different from each other, X in Chemical Formula 1 may include two or three kinds of halogens.

In Chemical Formula 1, A has a structure in which at least one deuterium is substituted in methylammonium. Thus, A can have a structure of CD₃N⁺D₃, CD₃N⁺D₂H, CD₃N⁺DH₂, CD₃N⁺H₃, CD₂HN⁺D₃, CD₂HN⁺D₂H, CD₂HN⁺DH₂, CD₂HN⁺H₃, CDH₂N⁺D₃, CDH₂N⁺D₂H, CDH₂N⁺DH₂, CDH₂N⁺H₃, CH₃N⁺D₃, CH₃N⁺D₂H, or CH₃N⁺DH₂.

Preferably, M' is Pb²⁺, Sn²⁺, Pd²⁺, Cu²⁺, Ge²⁺, Sr²⁺, Cd²⁺, Ca²⁺, Ni²⁺, Mn²⁺, Fe²⁺, Co²⁺, Sn²⁺, Yb²⁺, or Eu²⁺. More preferably, M' is Pb²⁺ or Sn²⁺, and most preferably, Pb²⁺.

Further, preferably, each X' is independently Cl⁻, Br⁻, or I⁻. Since the X' may be the same as or different from each other, X' in Chemical Formula 1 may include two or three kinds of halogens.

x represents a ratio of two kinds of perovskite structures existing in Chemical Formula 1, and is a real number of more than 0 and less than 1. Preferably, x is a real number of 0.6 or more and 0.8 or less, and more preferably 0.7.

Preferably, M and M' are the same as each other. More preferably, M and M' are Pb²⁺.

Preferably, X and X' all are the same. More preferably, X and X' all are Cl⁻, Br⁻, or I⁻.

Representative examples of the compound represented by Chemical Formula 1 are represented by Chemical Formula 1-1 or 1-2:

[Chemical Formula 1-1] (NH₂CHNH₂Pbl₃)_{0.7}(CD₃ND₂HPbX'₃)_{0.3}

[Chemical Formula 1-2] (NH₂CHNH₂Pbl₃)_{0.7}(CD₃ND₃PbX'₃)_{0.3}

In addition, the present invention provides a method for preparing a compound represented by Chemical Formula 1 including reacting (NH₂CHNH₂X)ₓ, (MX₂)ₓ, (AX')₍₁₋ₓ₎, and (M'X'₂)₍₁₋ₓ₎ to produce a compound represented by Chemical Formula 1.

Further, the present invention provides a solar cell including the compound represented by Chemical Formula 1 as an absorber.

The term "absorber" as used herein means a substance which absorbs light from a solar cell to generate an exciton, that is, an electron and a hole. As described above, the compound represented by Chemical Formula 1 is a perovskite compound and can be used as an absorber of a solar cell, and particularly has high humidity and light stability.

The solar cells used in the present invention may have a solar cell structure used in the art, except that the compound represented by Chemical Formula 1 is used as an absorber. As an example, the solar cell used in the present invention can be configured as follows:
a first electrode including a conductive transparent substrate;
an electron transport layer formed on the first electrode;
a light absorbing layer formed on the electron transport layer and including the compound represented by Chemical Formula 1;
a hole transport layer formed on the light absorbing layer; and
a second electrode formed on the hole transport layer.

In addition, the solar cell may be manufactured through the steps of:
1) forming an electron transport layer on a first electrode including a conductive transparent substrate;
2) adsorbing the compound represented by Chemical Formula 1 onto the electron transport layer, and heat-treating the same to form a light absorbing layer;
3) forming a hole transport layer on the light absorption layer; and
4) forming a second electrode on the hole transport layer.

The above-described conductive transparent substrate is not particularly limited as long as it is a conductive transparent substrate usually used in the field of solar cells. For example, fluorine-doped tin oxide (FTO), indium-doped tin oxide (ITO), ZnO, PEDOT:PSS, or the like can be used.

The electron transport layer may use a porous metal oxide, and preferably has a porous structure by metal oxide particles. As the metal oxide, TiO₂, SnO₂, ZnO, Nb₂O₅, Ta₂O₅, WO₃, W₂O₅, In₂O₃, Ga₂O₃, Nd₂O₃, PbO, or CdO may be used.

The hole transport layer may use a solid-state hole transport material or a liquid-phase electrolyte. As an example of the solid-state hole transport material, spiro-OMeTAD(2,2',7,7'-tetrakis-(N,N-di-p-methoxyphenylamine)9,9'-spirobifluorene), P3HT(poly(3-hexylthiophene)), PCPDTBT(poly[2,1,3-benzothiadiazole-4,7-diyl[4,4-bis(2-ethylhexyl)-4H-cyclopenta[2,1-b:3,4-b']dithiopen-2,6-diyl]]), PVK(poly(N-vinylcarbazole)), HTM-TFSI(1-hexyl-3-methylimidazolium bis(trifluoromethylsulfonyl)imide), Li-TFSI(lithium bis(trifluoromethanesulfonyl)imide), tBP(tert-butylpyridine), PDOT:PSS(poly(3,4-ethylenedioxythiophene) poly(styrenesulfonate)), or the like may be used. As the liquid-phase electrolyte, the one in which iodine and an additive have been dissolved in a solvent may be used. For example, one or more additives selected from the group consisting of urea, thiourea, tert-butylpyridine, guanidium thiocyanate, and the like may be used together with one or more solvents selected from the group consisting of ethyl acetate, acetonitrile, toluene, methoxypropionitrile, and the like.

As for the second electrode, a conductive layer containing one or more materials selected from the group consisting of Pt, Au, Ni, Cu, Ag, In, Ru, Pd, Rh, Ir, Os, C, and a conductive polymer may be formed on a glass substrate or a plastic substrate containing one or more materials selected from the group consisting of ITO, FTO, ZnO-Ga₂O₃ and tin-based oxide.

Further, absorption of the compound in the step 2 may be carried out for 10 seconds to 5 minutes by spin-coating, dip coating, screen coating, spray coating, electrospinning, or the like. In addition, the solvent for dispersing the compound represented by Chemical Formula 1 is not particularly limited as long as it is a solvent that easily dissolves perovskite, but gamma-butyrolactone, DMF and the like are preferable. After adsorption, the heat treatment temperature is preferably 40 to 300°C.

### [ADVANTAGEOUS EFFECTS]

As described above, the compound according to the present invention has a perovskite structure into which deuterium is introduced, thereby exhibiting high humidity and light stability, and thus can be useful as an absorber of a solar cell.

### [BRIEF DESCRIPTION OF THE DRAWINGS]

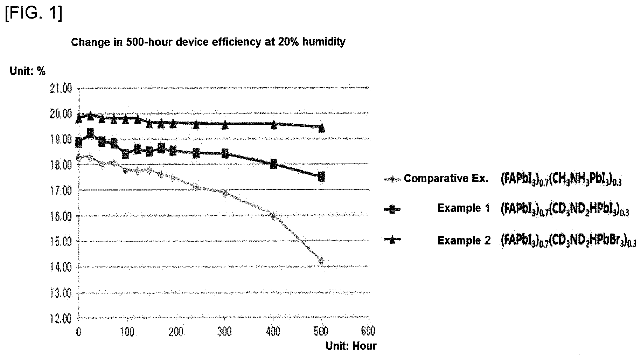

FIG. 1 shows the efficiency of the solar cells of the compounds prepared in Examples and Comparative Examples of the present invention.

### [DETAILED DESCRIPTION OF THE EMBODIMENTS]

Below, preferred examples will be described in order to better understand the present invention. However, these examples are provided for easier understanding of the invention only, and should not be construed as limiting the scope of the present invention thereto.

### Preparation Example 1: Preparation of methyl ammonium iodide-d₅

A 2L vacuum flask was injected with methyl amine-d₅ gas. The flask was maintained at -78°C (dry ice and acetone bath) for about 15 minutes until the gas was condensed to become liquid. 5 g of Methanol-d₄ was injected into the flask with a syringe and stirred for 30 minutes, and then the temperature was raised to 0°C. Hydriodic acid (HI 57 wt%) (22.66 mL, 0.17 mol) was added and stirred for 1.5 hours. The solvent was removed using a rotary evaporator, washed with diethyl ether, and then filtered and vacuum-dried to obtain methyl ammonium iodide-d₅ (10.98 g, 80.4%).
²H NMR (spinning rate = 18 kHz) (600 MHz, ppm): 1.1(3, s), 5.2(2, s)
¹H NMR (D₂O(700 MHz), ppm): 4.28(1, s)

### Preparation Example 2: Preparation of Methyl ammonium bromide-d₅

Methyl ammonium bromide-d₅ was prepared in the same manner as in Preparation Example 1, except that hydrobromic acid (HBr 48 wt%) was used instead of hydriodic acid (HI 57 wt%).
²H NMR (spinning rate = 18 kHz) (600 MHz, ppm): 1.2(3, s), 5.3(2, s)
¹H NMR (D₂O(700 MHz), ppm): 4.30(1, s)

### Preparation Example 3: Preparation of Methyl ammonium chloride-d₅

Methyl ammonium chloride-d₅ was prepared in the same manner as in Preparation Example 1, except that hydrochloric acid (HCI 37 wt%) was used instead of hydriodic acid (HI 57 wt%).
²H NMR (spinning rate = 18 kHz) (600 MHz, ppm): 1.2(3, s), 5.4(2, s)
¹H NMR (D₂O(700 MHz), ppm): 4.31(1, s)

### Preparation Example 4: Preparation of Methyl ammonium fluoride-d₅

Methyl ammonium fluoride-d₅ was prepared in the same manner as in Preparation Example 1, except that hydrofluoric acid (HF 48 wt%) was used instead of hydriodic acid (HI 57 wt%).
²H NMR (spinning rate = 18 kHz) (600 MHz, ppm): 1.2(3, s), 5.5(2, s)
¹H NMR (D₂O(700 MHz), ppm): 4.32(1, s)

### Preparation Example 5: Preparation of Methyl ammonium iodide-d₆

Methyl ammonium iodide-d₆ was prepared in the same manner as in Preparation Example 1, except that deuterium iodide (DI 57wt%) was used instead of hydriodic acid (HI 57 wt%).
²H NMR (spinning rate = 18 kHz) (600 MHz, ppm): 1.1(3, s), 5.2(3, s)

### Preparation Example 6: Preparation of Methyl ammonium bromide-d₆

Methyl ammonium bromide-d₆ was prepared in the same manner as in Preparation Example 2, except that deuterium bromide (DBr 47wt%) was used instead of hydrobromic acid (HBr 48 wt%).
²H NMR (spinning rate = 18 kHz) (600 MHz, ppm): 1.2(3, s), 5.3(3, s)

### Preparation Example 7: Preparation of Methyl ammonium chloride-d₆

Methyl ammonium chloride-d₆ was prepared in the same manner as in Preparation Example 3, except that deuterium chloride (DCI 35wt%) was used instead of hydrochloric acid (HCl 37 wt%).
²H NMR (spinning rate = 18 kHz) (600 MHz, ppm): 1.2(3, s), 5.4(3, s)

### Preparation Example 8: Preparation of FAI(formamidinium iodide)

Formamidine acetate was placed in a 500 mL flask and cooled on an ice bath. After 15 minutes, hydriodic acid (HI) (2 eq) was dropped using a dropping funnel under an argon atmosphere. After stirring at 50°C for 30 minutes, all remaining solvent was removed at 50°C with a rotary evaporator. Precipitated FAI was added to diethyl ether, washed with stirring for 10 minutes, filtered, and the procedure was repeated one more time. The washed FAI was added to ethanol and dissolved with stirring at 50°C. Then, the solution was placed in a refrigerator and recrystallized for one day. After recrystallization, the product was filtered and dried in a vacuum oven at 50°C for 12 hours to obtain a final product (4.21 g, 39%).
¹H NMR (D₂O(700 MHz), ppm): 7.2(5, s)

### Preparation Example 9: Preparation of Methyl ammonium iodide

Methyl ammonium iodide (yield: 80.4%) was prepared in the same manner as in Preparation Example 8, except that Methyl amine solution (40 wt% in methanol) was used instead of formamidine acetate.
¹H NMR (D₂O(700 MHz), ppm): 8.52(3, s), 2.47(3, s)

### Comparative Example 1: Preparation of (FAPbl₃)_{0.7}(CH₃NH₃Pbl₃)_{0.3}

Formamidinium iodide prepared in Preparation Example 8 and lead iodide(II) were dissolved in 1-methyl-pyrrolidone in a molar ratio of 1:1, and methyl ammonium iodide prepared in Preparation Example 9 and lead iodide(II) were dissolved in 1-methyl-pyrrolidone in a molar ratio of 1:1. Each solution was mixed in a molar ratio of 7:3 and stirred at 70°C for 2 hours to prepare 40 wt% of (FAPbl₃)_{0.7}(CH₃NH₃Pbl₃)_{0.3} solution.

### Example 1: Preparation of (FAPbl₃)_{0.7}(CD₃ND₂HPbl₃)_{0.3}

Formamidinium iodide prepared in Preparation Example 8 and lead iodide(II) were dissolved in 1-methyl-pyrrolidone in a molar ratio of 1:1, and methyl ammonium iodide-d₅ prepared in Preparation Example 1 and lead iodide(II) were dissolved in 1-methyl-pyrrolidone in a molar ratio of 1:1. Each solution was mixed in a molar ratio of 7:3 and stirred at 70°C for 2 hours to prepare 40 wt% of (FAPbl₃)_{0.7}(CD₃ND₂HPbl₃)_{0.3} solution.

### Example 2: Preparation of (FAPbl₃)_{0.7}(CD₃ND₂HPbBr₃)_{0.3}

Formamidinium iodide prepared in Preparation Example 8 and lead iodide(II) were dissolved in 1-methyl-pyrrolidone in a molar ratio of 1:1, and methyl ammonium bromide-d₅ prepared in Preparation Example 2 and lead iodide(II) were dissolved in 1-methyl-pyrrolidone in a molar ratio of 1:1. Each solution was mixed in a molar ratio of 7:3 and stirred at 70°C for 2 hours to prepare 40 wt% of (FAPbl₃)_{0.7}(CD₃ND₂HPbBr₃)_{0.3}.

### Example 3: Preparation of (FAPbl₃)_{0.7}(CD₃ND₂HPbCl₃)_{0.3}

Formamidinium iodide prepared in Preparation Example 8 and lead iodide(II) were dissolved in 1-methyl-pyrrolidone in a molar ratio of 1:1, and methyl ammonium chloride-d₅ prepared in Preparation Example 3 and lead chloride(II) were dissolved in 1-methyl-pyrrolidone in a molar ratio of 1:1. Each solution was mixed in a molar ratio of 7:3 and stirred at 70°C for 2 hours to prepare 40 wt% of (FAPbl₃)_{0.7}(CD₃ND₂HPbCl₃)_{0.3} solution.

### Example 4: Preparation of (FAPb)₃)_{0.7}(CD₃ND₂HPbF₃)_{0.3}

Formamidinium iodide prepared in Preparation Example 8 and lead iodide (II) were dissolved in 1-methyl-pyrrolidone in a molar ratio of 1:1. Methyl ammonium fluoride-d₅ iodide prepared in Preparation Example 4 and lead fluoride(II) were dissolved in 1-methyl-pyrrolidone in a molar ratio of 1:1. Each solution was mixed in a molar ratio of 7:3 and stirred at 70°C for 2 hours to prepare 40 wt% of (FAPbl₃)_{0.7}(CD₃ND₂HPbF₃)_{0.3} solution.

### Example 5: Preparation of (FAPb)₃)_{0.7}(CD₃ND₃Pb)₃)_{0.3}

Formamidinium iodide prepared in Preparation Example 8 iodide and lead iodide (II) were dissolved in 1-methyl-pyrrolidone in a molar ratio of 1:1. Methyl ammonium iodide-d₆ prepared in Preparation Example 5 and lead iodide (II) were dissolved in 1-methyl-pyrrolidone in a molar ratio of 1:1. Each solution was mixed in a molar ratio of 7:3 and stirred at 70°C for 2 hours to prepare 40 wt% of (FAPbl₃)_{0.7}(CD₃ND₃Pbl₃)_{0.3} solution.

### Example 6: Preparation of (FAPb)₃)_{0.7}(CD₃ND₃PbBr₃)_{0.3}

Formamidinium iodide prepared in Preparation Example 8 and lead iodide(II) were dissolved in 1-methyl-pyrrolidone in a molar ratio of 1:1, and methyl ammonium bromide-d₆ prepared in Preparation Example 6 and lead bromide (II) were dissolved in 1-methyl-pyrrolidone in a molar ratio of 1:1. Each solution was mixed in a molar ratio of 7:3 and stirred at 70°C for 2 hours to prepare 40 wt% of (FAPbl₃)_{0.7}(CD₃ND₃PbBr₃)_{0.3} solution.

### Example 7: Preparation of (FAPbl₃)_{0.7}(CD₃ND₃PbCl₃)_{0.3}

Formamidinium iodide prepared in Preparation Example 8 and lead iodide (II) were dissolved in 1-methyl-pyrrolidone in a molar ratio of 1:1. Methyl ammonium chloride-d₆ prepared in Preparation Example 7 and lead chloride(II) were dissolved in 1-methyl-pyrrolidone in a molar ratio of 1:1. Each solution was mixed in a molar ratio of 7:3 and stirred at 70°C for 2 hours to prepare 40 wt% of (FAPbl₃)_{0.7}(CD₃ND₃PbCl₃)_{0.3} solution.

### Experimental Example

FTO glass (Pikington, TEC-7, 7 Ω / sq) was washed with ethanol using ultrasonic waves for 40 minutes. FTO substrate was coated by a spin coating method using 0.1M titanium(IV) bis(ethylacetoacetato)diisopropoxide/1-butanol solution (Preparation of a first electrode). After heat treatment at 500°C for 15 minutes, a solution prepared by diluting 1 g of TiO₂ paste with 10 mL of ethanol was coated with TiO₂ paste by a spin coating method, followed by heat treatment at 500°C for 1 hour.

Each solution prepared in Examples 1 to 8 and Comparative Example was dropped onto an FTO glass coated with a TiO₂ film (2.5 × 2.5 cm²), and coated by a spin coating method, to which toluene was added as a non-solvent in a drop wise manner 10 seconds before the end. The reaction product was heat-treated on a hotplate at 100°C for 10 minutes. Subsequently, a hole transport layer was prepared by coating 60 mM of Spiro-OMeTAD/Li-TFSI/Tert-butylpyridine/chlorobenzene (Aldrich) by a spin coating method. The anode was etched with a width of 2.5 cm and a length of 0.5 cm and masked, and then Au was deposited to prepare an electrode (second electrode).

The efficiency of the solar cell was measured using the solar cell manufactured as described above, and the results are shown in Table 1 and FIG. 1 below. The humidity during measurement was maintained at 20%. Table 1 shows the measurement results at the time of the first measurement, and FIG. 1 shows the power generation efficiency measured with the lapse of time.

**[Table 1]**

| | Short-circuit current density (mA/cm²) | Open-circuit voltage (V) | Performance index (%) | Power generation efficiency (%) |
|---|---|---|---|---|
| Comparative Example | 23.58 | 1.06 | 0.73 | 18.28 |
| Example 1 | 24.57 | 1.03 | 0.74 | 18.92 |
| Example 2 | 23.59 | 1.09 | 0.76 | 19.83 |

As shown in Table 1 and FIG. 1, at the time of the initial measurement, the solar cells of Examples had higher power generation efficiency than the solar cell of Comparative Example. Furthermore, it was confirmed that in Comparative Example, the power generation efficiency was rapidly lowered over time after the initial measurement, whereas in Examples, the power generation efficiency was maintained at a high numerical value for a long time.

## Claims

1. A compound represented by Chemical Formula 1 below:
[Chemical Formula 1] (NH₂CHNH₂MX₃)ₓ(AM'X'₃)₍₁₋ₓ₎
in Chemical Formula 1,
M is a divalent metal cation,
X is the same or difference halogen,
A is CD₃₋ₐHₐN⁺D_{3-b}H_{b},
wherein a is an integer from 0 to 3, and b is an integer from 0 to 3, with the exception of the case where a is 3 and b is 3,
M' is a divalent metal cation,
X' are the same or different halogen, and
x is a real number of greater than 0 and less than 1, and
wherein A is CD₃N⁺D₃, CD₃N⁺D₂H, CD₃N⁺DH₂, CD₃N⁺H₃, CD₂HN⁺D₃, CD₂HN⁺D₂H, CD₂HN⁺DH₂, CD₂HN⁺H₃, CDH₂N⁺D₃, CDH₂N⁺D₂H, CDH₂N⁺DH₂, CDH₂N⁺H₃, CH₃N⁺D₃, CH₃N⁺D₂H, or CH₃N⁺DH₂.

2. The compound according to claim 1, wherein M is Pb²⁺, Sn²⁺, Pd²⁺, Cu²⁺, Ge²⁺, Sr²⁺, Cd²⁺, Ca²⁺, Ni²⁺, Mn²⁺, Fe²⁺, Co²⁺, Sn²⁺, Yb²⁺, or Eu²⁺.

3. The compound according to claim 1, wherein each X is independently Cl⁻, Br⁻, or I⁻.

4. The compound according to claim 1, wherein M' is Pb²⁺, Sn²⁺, Pd²⁺, Cu²⁺, Ge²⁺, Sr²⁺, Cd²⁺, Ca²⁺, Ni²⁺, Mn²⁺, Fe²⁺, Co²⁺, Sn²⁺, Yb²⁺, or Eu²⁺.

5. The compound according to claim 1, wherein each X' is independently Cl⁻, Br⁻, or I⁻.

6. The compound according to claim 1, wherein x is a real number of 0.6 or more and 0.8 or less.

7. The compound according to claim 1, wherein M and M' are the same as each other.

8. The compound according to claim 1, wherein X and X' all are the same.

9. The compound according to claim 1, wherein the compound represented by Chemical Formula 1 is represented by Chemical Formula 1-1 or 1-2:
[Chemical Formula 1-1] (NH₂CHNH₂Pbl₃)_{0.7}(CD₃ND₂HPbX'₃)_{0.3}
[Chemical Formula 1-2] (NH₂CHNH₂Pbl₃)_{0.7}(CD₃ND₃PbX'₃)_{0.3}

10. A solar cell comprising the compound of any one of claims 1 to 9 as an absorber.

11. The solar cell according to claim 10, wherein the solar cell has the following structure:
a first electrode including a conductive transparent substrate;
an electron transport layer formed on the first electrode;
a light absorbing layer formed on the electron transport layer and including the compound represented by Chemical Formula 1;
a hole transport layer formed on the light absorbing layer; and
a second electrode formed on the hole transport layer.

## Patentansprüche

1. Verbindung mit der chemischen Formel 1 unten:
[Chemische Formel 1] (NH₂CHNH₂MX₃)ₓ(AM'X'₃)₍₁₋ₓ₎
worin in der chemischen Formel 1
M ein bivalentes Metallkation ist,
X ein gleiches oder unterschiedliches Halogen ist,
A CD₃₋ₐHₐN⁺D_{3-b}H_{b} ist,
worin a eine ganze Zahl von 0 bis 3 ist und b eine ganze Zahl von 0 bis 3 ist, mit der Ausnahme des Falls, bei dem a 3 und b 3 sind,
M' ein bivalentes Metallkation,
X' gleiches oder unterschiedliches Halogen ist und
x eine reale Zahl von mehr als 0 und weniger als 1 ist und
worin A CD₃N⁺D₃, CD₃N⁺D₂H, CD₃N⁺DH₂, CD₂N⁺H₃, CD₂HN⁺D₃, CD₂HN⁺D₂H, CD₂HN⁺DH₂, CD₂HN⁺H₃, CDH₂N⁺D₃, CDH₂N⁺D₂H, CDH₂N⁺DH₂, CDH₂N⁺H₃, CH₃N⁺D₃, CH₃N⁺D₂H oder CH₃N⁺DH₂ ist.

2. Verbindung gemäß Anspruch 1, worin M Pb²⁺, Sn²⁺, Pd²⁺, Cu²⁺, Ge²⁺, Sr²⁺, Cd²⁺, Ca²⁺, Ni²⁺, Mn²⁺, Fe²⁺, Co²⁺, Sn²⁺, Yb²⁺, oder Eu²⁺ ist.

3. Verbindung gemäß Anspruch 1, worin jedes X unabhängig Cl⁻, Br⁻ oder I⁻ ist.

4. Verbindung gemäß Anspruch 1, worin M' Pb²⁺, Sn²⁺, Pd²⁺, Cu²⁺, Ge²⁺, Sr²⁺, Cd²⁺, Ca²⁺, Ni²⁺, Mn²⁺, Fe²⁺, Co²⁺, Sn²⁺, Yb²⁺, oder Eu²⁺ ist.

5. Verbindung gemäß Anspruch 1, worin jedes X' unabhängig Cl⁻, Br⁻ oder I⁻ ist.

6. Verbindung gemäß Anspruch 1, worin x eine reale Zahl von 0,6 oder mehr und 0,8 oder weniger ist.

7. Verbindung gemäß Anspruch 1, worin M und M' gleich zueinander sind.

8. Verbindung gemäß Anspruch 1, worin X und X' jeweils gleich sind.

9. Verbindung gemäß Anspruch 1, worin die Verbindung mit der chemischen Formel 1 durch die chemische Formel 1-1 oder 1-2 dargestellt ist:
[Chemische Formel 1-1] (NH₂CHNH₂PbI₃)_{0,7}(CD₃ND₂HPbX'₃)_{0,3}
[Chemische Formel 1-2] (NH₂CHNH₂PbI₃)_{0,7}(CD₃ND₃PbX'₃)_{0,3}.

10. Solarzelle, enthaltend die Verbindung gemäß einem der Ansprüche 1 bis 9 als Absorber.

11. Solarzelle gemäß Anspruch 10, worin die Solarzelle die folgende Struktur hat:
eine erste Elektrode mit einem leitenden transparenten Substrat,
eine Elektronentransportschicht, gebildet auf der ersten Elektrode,
eine Lichtabsorptionsschicht, gebildet auf der Elektronentransportschicht und mit der Verbindung mit der chemischen Formel 1,
eine Lochtransportschicht, gebildet auf der Lichtabsorptionsschicht, und
eine zweite Elektrode, gebildet auf der Lochtransportschicht.

## Revendications

1. Composé représenté par la Formule Chimique 1 ci-dessous :
[Formule Chimique 1] (NH₂CHNH₂MX₃)ₓ(AM'X'₃)₍₁₋ₓ₎
dans la Formule Chimique 1,
M est un cation métallique divalent,
X est l'halogène différent ou identique,
A is CD₃₋ₐHₐN⁺D_{3-b}H_{b},
dans lequel a est un entier de 0 à 3, et b est un entier de 0 à 3, à l'exception du cas où a est 3 et b est 3,
M' est un cation métallique divalent,
X' sont l'halogène différent ou identique, et
x est un nombre réel supérieur à 0 et inférieur à 1, et
dans lequel A est CD₃N⁺D₃, CD₃N⁺D₂H, CD₃N⁺DH₂, CD₃N⁺H₃, CD₂HN⁺D₃, CD₂HN⁺D₂H, CD₂HN⁺DH₂, CD₂HN⁺H₃, CDH₂N⁺D₃, CDH₂N⁺D₂H, CDH₂N⁺DH₂, CDH₂N⁺H₃, CH₃N⁺D₃, CH₃N⁺D₂H, ou CH₃N⁺DH₂.

2. Le composé selon la revendication 1, dans lequel M est Pb²⁺, Sn²⁺, Pd²⁺, Cu²⁺, Ge²⁺, Sr²⁺, Cd²⁺, Ca²⁺, Ni²⁺, Mn²⁺, Fe²⁺, Co²⁺, Sn²⁺, Yb²⁺, ou Eu²⁺.

3. Le composé selon la revendication 1, dans lequel chaque X est indépendamment Cl⁻, Br⁻, ou I⁻.

4. Le composé selon la revendication 1, dans lequel M' est Pb²⁺, Sn²⁺, Pd²⁺, Cu²⁺, Ge²⁺, Sr²⁺, Cd²⁺, Ca²⁺, Ni²⁺, Mn²⁺, Fe²⁺, Co²⁺, Sn²⁺, Yb²⁺, ou Eu²⁺.

5. Le composé selon la revendication 1, dans lequel chaque X' est indépendamment Cl⁻, Br⁻, ou I⁻.

6. Le composé selon la revendication 1, dans lequel x est un nombre réel de 0,6 ou plus et 0,8 ou moins.

7. Le composé selon la revendication 1, dans lequel M et M' sont identiques les uns par rapport aux autres.

8. Le composé selon la revendication 1, dans lequel X et X' sont tous identiques.

9. Le composé selon la revendication 1, dans lequel le composé représenté par la Formule Chimique 1 est représenté par la Formule Chimique 1-1 ou 1-2 :
[Formule Chimique 1-1] (NH₂CHNH₂Pbl₃)_{0.7}(CD₃ND₂HPbX'₃)_{0.3}
[Formule Chimique 1-2] (NH₂CHNH₂Pbl₃)_{0.7}(CD₃ND₃PbX'₃)_{0.3}

10. Cellule solaire comprenant le composé de l'une quelconque des revendications 1 à 9 en tant qu'un absorbeur.

11. La cellule solaire de la revendication 10, dans laquelle la cellule solaire a la structure suivante :
une première électrode comportant un substrat transparent conducteur ;
une couche de transport d'électrons formée sur la première électrode ;
une couche d'absorption de lumière formée sur la couche de transport d'électrons et comportant le composé représenté par la Formule Chimique 1 ;
une couche de transport de trous formée sur la couche d'absorption de lumière ; et
une deuxième électrode formée sur la couche de transport de trous.
